# EUROPEAN PATENT APPLICATION

(11) **EP 4 556 592 A2**
(43) Date of publication of application: **21.05.2025**
(21) Application number: 24212779.3
(22) Date of filing: 13.11.2024
(51) Int. Cl.: C23C 16/26, H01J 37/317

(54) **CARBON CONTAINING PRECURSORS FOR BEAM-INDUCED DEPOSITION**

(30) Priority: 17.11.2023 US 202318512815
(71) Applicant: FEI COMPANY, Hillsboro, OR 97124 (US)
(72) Inventor: MITCHSON, Gavin, Hillsboro, 97124 (US); RUE, Chad, Hillsboro, 97124 (US)
(74) Representative: Boult Wade Tennant LLP

(57) **Abstract**

Systems, components, and methods for beam-induced deposition are described. A charged particle beam system can include a vacuum chamber. The system can include a charged particle beam source, operably coupled with the vacuum chamber and including an emitter section and a column section, the charged particle beam source being configured to generate a beam of charged particles and to direct the beam of charged particles into the vacuum chamber. The system can include a precursor source, operably coupled with the vacuum chamber and configured to direct a gas stream comprising a precursor into the vacuum chamber. The precursor can include a hydrocarbon having a vapor pressure greater than about 1.6x10-4 mbar at about 293 K and about 101.3 kPa, and wherein the hydrocarbon is not naphthalene.

## Description

### CROSS-REFERENCE TO RELATED APPLICATION

This application claims priority to US Non-Provisional Application S/N 18/512,815, filed November 17, 2023, the disclosure of which is incorporated herein by reference in its entirety.

### TECHNICAL FIELD

Embodiments of the present disclosure are directed to charged particle beam systems and components, as well as materials, algorithms, and methods for their operation. In particular, some embodiments are directed toward techniques for beam-induced deposition of material.

### BACKGROUND

Charged particle beam systems can be used to prepare samples for further microanalysis, for example, in a transmission electron microscope ("TEM"). Where samples are drawn from larger materials, such as multilayer CMOS wafers, sample preparation procedures can include deposition and removal operations that employ focused ion beam ("FIB") and electron beam systems. Dual-beam instruments, including a FIB and a scanning electron microscope ("SEM"), can be used to locate and extract a sample from a region of interest ("ROI") in a wafer for further microanalysis.

Energy from the charged particle beam (e.g., ion beam and/or electron beam) can be used to elicit a chemical reaction in a precursor near the surface of a substrate. In an example, a dual-beam system can include a gas injector system ("GIS") that delivers the precursor to the vicinity of the ROI. The gaseous precursor can be at least partially decomposed in the vicinity of the ROI or otherwise activated, resulting in a reaction that forms a material deposit on the sample surface. Material deposition in this manner, referred to as beam-induced deposition, permits localized and/or patterned layers of material to be disposed onto the surface(s) of a substrate and/or sample. Further, the deposition rate can be controlled using the operating parameters of the charged particle beam and/or the concentration and flux of the precursor near the surface. In this way, beam-induced deposition offers a flexible approach to precise application of materials to surfaces. For example, a metal-containing precursor can be decomposed and deposited onto a sample to form a conductive trace. In another example, carbonaceous material can be formed by the decomposition of carbon-containing precursors.

Unfortunately, carbon precursors can include polyaromatic hydrocarbons (PAHs). Increasingly, environmental health and safety concerns associated with exposure, use, and disposal of PAHs make their application in such techniques undesirable. Naphthalene, for example, is a common carbon precursor that is used to deposit carbon films using dual-beam systems. The Agency for Toxic Substances and Disease Registry of the United States Centers for Disease Control, in its Substance Priority List, identifies naphthalene as a chemical of greater concern than other more recognizable hazards, including plutonium, based on factors including exposure risk, health risks, and risk of environmental degradation. There is a need, therefore, for carbon precursors that pose a reduced risk to human users and to the environment, without sacrificing performance and compatibility with existing charged particle beam systems.

### BRIEF SUMMARY

The forthcoming aspects and embodiments can be practiced alone or in combination. In a first aspect, a charged particle beam system can include a vacuum chamber. The system can include a charged particle beam source, operably coupled with the vacuum chamber and including an emitter section and a column section, the charged particle beam source being configured to generate a beam of charged particles and to direct the beam of charged particles into the vacuum chamber. The system can include a precursor source, operably coupled with the vacuum chamber and configured to direct a gas stream comprising a precursor into the vacuum chamber. The precursor can include a hydrocarbon having a vapor pressure greater than about 1.6x10-4 mbar at about 293 K and about 101.3 kPa, and wherein the hydrocarbon is not naphthalene.

In some embodiments, the hydrocarbon is not included in a Substance Priority List compiled by the Agency for Toxic Substances and Disease Registry of the United States Centers for Disease Control and publicly available as of 2023. The hydrocarbon can be or include a biphenyl. The biphenyl can include one or more substituents, selected from a group consisting of: methyl, ethyl, propyl, butyl, amine, amide, acetyl, carboxyl, phosphine, ketone, and ether. The hydrocarbon can be or include a substituted-naphthalene. The hydrocarbon can be selected from a group consisting of: methane, ethylene, propane, styrene, camphor, menthol, benzoic acid, cyclohexane, cyclohexanone, cyanononane, acetone, methanol, nitromethane, acetonitrile, formic acid, acetic acid, propionic acid, and acrylic acid.

In some embodiments, the precursor reaches a substantially equal or greater equilibrium surface coverage, θ, relative to that of naphthalene at a given set of environmental conditions in the vacuum chamber and for a given sample, with θ being defined using a relevant adsorption isotherm model. The precursor can be characterized by a substantially equal or greater admolecule surface mobility, relative to that of naphthalene at a given set of environmental conditions in the vacuum chamber and for a given sample.

In some embodiments, the system further includes a sample stage, disposed in the vacuum chamber and defining a locus in the vacuum chamber such that the charged particle beam source and the precursor source are configured to direct the beam of charged particles and the gas stream, respectively, toward the locus.

In some embodiments, the system further includes control circuitry, operably coupled with the charged particle beam source and the precursor source and one or more non-transitory machine-readable storage media, operably coupled with the control circuitry and storing instructions. When executed by the system, the instructions can cause the system to perform operations. The operations can include directing the gas stream into the vacuum chamber toward a locus defined in the vacuum chamber and irradiating a region including the locus using the beam of charged particles. Irradiating the region can include directing a current density from about 0.1 pA/µm2 to about 300 pA/µm2 onto a surface positioned substantially at the locus. The operations can further include heating the precursor at a temperature from about 273 K to about 385 K.

In a second aspect, a method of generating a carbonaceous material in a charged particle beam system includes directing a gas stream into a vacuum chamber of the charged particle beam system, the gas stream comprising a precursor, and irradiating a region of a sample using a beam of charged particles. The precursor can include a hydrocarbon having a vapor pressure greater than about 1.6x10-4 mbar at about 293 K and about 101.3 kPa, where the hydrocarbon is not naphthalene.

In some embodiments, the beam of charged particles can include argon ions, xenon ions and/or gallium ions. The beam of charged particles can include electrons. The beam of charged particles can have a current density from about 0.1 pA/µm² to about 300 pA/µm². The beam of charged particles can have a beam energy from about 1 keV to about 50 keV. In some embodiments, the method further includes heating the precursor to a temperature from about 273 K to about 385 K.

The terms and expressions which have been employed are used as terms of description and not of limitation, and there is no intention in the use of such terms and expressions of excluding any equivalents of the features shown and described or portions thereof, but it is recognized that various modifications are possible within the scope of the claimed subject matter. Thus, it should be understood that although the present claimed subject matter has been specifically disclosed by embodiments and optional features, modification, combination, and variation of the concepts herein disclosed can be resorted to by those skilled in the art, and that such modifications and variations are considered to be within the scope of this disclosure as defined by the appended claims.

### BRIEF DESCRIPTION OF THE DRAWINGS

The foregoing aspects and many of the attendant advantages of the present disclosure will become more readily appreciated as the same become better understood by reference to the following detailed description, when taken in conjunction with the accompanying drawings.
FIG. 1 is a schematic diagram illustrating an example charged particle beam system, in accordance with some embodiments of the present disclosure.
FIG. 2 is a schematic diagram illustrating an example charged particle beam system performing operations of a process for beam-induced deposition, in accordance with some embodiments of the present disclosure.
FIG. 3 is a block flow diagram illustrating an example process 300 for beam-induced deposition, in accordance with some embodiments of the present disclosure.
FIG. 4A is an electron micrograph of an example sample surface on which a carbonaceous material has been disposed using a biphenyl precursor, prepared in accordance with some embodiments of the present disclosure.
FIG. 4B is an electron micrograph of the example carbonaceous material of FIG. 4A, in partial elevation, prepared in accordance with some embodiments of the present disclosure.
FIG. 4C is an electron micrograph of an example sample surface on which a carbonaceous material has been disposed using an acrylic acid precursor, prepared in accordance with some embodiments of the present disclosure.
FIGs. 5A-5D are data plots illustrating the influence of operating parameters of an example charged particle beam system on performance in beam-induced deposition using a biphenyl precursor, in accordance with embodiments of the present disclosure.
FIGs. 6A-6D are data plots illustrating the influence of operating parameters of an example charged particle beam system on performance in beam-induced deposition using acrylic acid precursor, in accordance with embodiments of the present disclosure.
FIGs. 7A-7C are data plots illustrating comparative data generated using an example charged particle beam system in electron beam-induced deposition using biphenyl precursor and naphthalene precursor, in accordance with embodiments of the present disclosure.
FIGs. 8A-8B are data plots illustrating comparative data generated using an example charged particle beam system in gallium ion beam-induced deposition using biphenyl precursor and naphthalene precursor, in accordance with embodiments of the present disclosure.
FIGs. 9A-9B are data plots illustrating comparative data generated using an example charged particle beam system in xenon ion beam-induced deposition using biphenyl precursor and naphthalene precursor for various operating conditions, in accordance with embodiments of the present disclosure.
FIGs. 10A-10C are data plots illustrating comparative data generated using an example charged particle beam system in gallium ion beam-induced deposition using biphenyl precursor and naphthalene precursor, in accordance with embodiments of the present disclosure.
FIGs. 11A-11C are data plots illustrating comparative data generated using an example charged particle beam system in argon ion beam-induced deposition using biphenyl precursor and naphthalene precursor, in accordance with embodiments of the present disclosure.

In the drawings, like reference numerals refer to like parts throughout the various views unless otherwise specified. Not all instances of an element are necessarily labeled to reduce clutter in the drawings where appropriate. The drawings are not necessarily to scale, emphasis instead being placed upon illustrating the principles being described.

### DETAILED DESCRIPTION

While illustrative embodiments have been described, it will be appreciated that various changes can be made therein without departing from the spirit and scope of the disclosure. In the forthcoming paragraphs, embodiments of a charged particle beam instrument system, components, and methods for beam-induced deposition are described.

Embodiments of the present disclosure include systems, methods, algorithms, and non-transitory media storing computer-readable instructions for beam-induced deposition. In an illustrative example, a charged particle beam system includes a vacuum chamber, a charged particle beam source, operably coupled with the vacuum chamber and including an emitter section and a column section, the charged particle beam source being configured to generate a beam of charged particles and to direct the beam of charged particles into the vacuum chamber, and a precursor source, operably coupled with the vacuum chamber and configured to direct a gas stream comprising a precursor into the vacuum chamber. In this example, the precursor includes a hydrocarbon having a vapor pressure greater than about 1.6×10⁻⁴ mbar at about 293 K and about 101.3 kPa, where the hydrocarbon is not naphthalene or does not include a naphthalene moiety. As described in the forthcoming section, embodiments of the present disclosure, including those in accordance with the example above, exhibit comparable or improved performance in beam-induced deposition (e.g., of carbonaceous materials, films, layers, etc.), while also reducing the environmental, health, and safety risks of such processes.

The following detailed description focuses on embodiments of e-beam assisted deposition and dual-beam systems in the interest of simplicity of description, but it is contemplated that additional and/or alternative instrument systems can be improved through the use of the techniques described. To that end, embodiments are not limited to such systems, but rather are contemplated for analytical instrument systems where a chemically stable precursor can be decomposed and/or otherwise induced to form a material deposit on a substrate through irradiation. In an illustrative example, focused ion beams, broad ion beams, focused electron beams, divergent electron beams, energetic photons (e.g., lasers, flash lamps, x-rays, etc), as well as other forms of electromagnetic radiation, alone or in combination, can be applied to assisted deposition techniques. Similarly, while embodiments of the present disclosure focus on carbon precursors, additional and/or alternative precursor compositions are contemplated, including but not limited to organometallic compounds (e.g., metallocenes, biferrocenes, metallocenophanes, etc.).

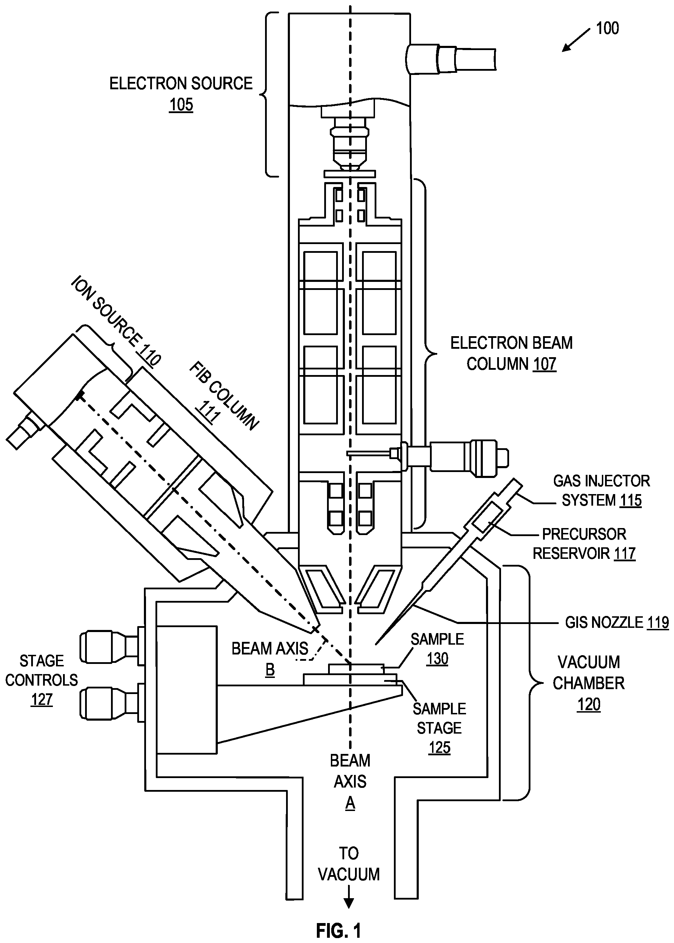

FIG. 1 is a schematic diagram illustrating an example charged particle beam system 100, in accordance with some embodiments of the present disclosure. The example system 100 includes an electron source 105, an electron beam column 107, an ion source 110, a focused ion beam ("FIB") column 111, a gas injection system ("GIS") 115, a vacuum chamber 120, and a sample stage 125. The electron beam column 105 is illustrated as a scanning electron microscope (SEM) column, such that the example system 100 corresponds to a dual beam FIB-SEM system. The electron beam column 107, the FIB column 111, and the GIS 115 are illustrated as being operably coupled with the vacuum chamber 120, with the electron beam column 107 defining a first beam axis A and the FIB column 111 defining a second beam axis B. The axes A and B are illustrated converging onto a region of a sample 130, with the GIS 115 oriented toward the region of the sample 130 and configured to direct a gas stream including a precursor into the vacuum chamber.

The electron source 105 can include one or more emitters configured to generate electrons and to direct the electrons into the electron beam column 107. The emitters can include thermionic emitters, Schottky emitters, field-emission source emitters, or combinations thereof, operably coupled to power systems configured to apply a high-voltage (e.g., on the order of kilovolts to hundreds of kilovolts) to an emission region of the emitter material. For example, the electron source 105 can include a lanthanum hexaboride (LaB₆) emitter crystal to which a high electrical potential is applied to elicit the emission of electrons from a tip of the emitter crystal. In this way, a beam of electrons is directed into the electron beam column. The electron beam column 107 includes electromagnetic optics (e.g., electrostatic lenses, electromagnetic lenses, monochromators, etc.) and apertures configured to shape, focus, defocus, and direct the beam of electrons such that the beam is focused onto the sample 130, in accordance with a set of operating parameters. The operating parameters can include a beam current, a beam energy (e.g., in volts, in electron volts, or the like), a magnification parameter, a scan pattern, a dwell time, and/or one or more pulse parameters. In this way, the example system 100 can function as an SEM to image portions of the sample 130 and/or can be used for e-beam assisted deposition of material onto the sample 130 (e.g., in coordination with the GIS 115). In an illustrative example, the beam energy can be from about 1 keV to about 50 keV, including subranges, fractions, or interpolations thereof. Beam energies below about 1 keV can correspond with reduced pattern fidelity, while beam energies above about 50 keV can reduce the secondary electron yield below a level at which deposition can be impaired significantly or negligible . To that end, precursor decomposition and deposition reactions can be mediated by secondary electrons emitted from the sample 130, which are characterized by lower energies than the primary electrons of the beam (e.g., at about 50 eV or less). In this way, the beam energy can be selected at least in part based on the secondary electron emission function for the material of the sample 130, which can depend at least in part on the beam energy.

The ion source 110 can include one or more components configured to generate a beam of ions and to direct the ions into the FIB column 111. The ions can include metal ions and/or nonmetal ions (e.g., noble gas, halogen, oxygen, nitrogen, or the like). To that end, the ion source 110 can include a plasma source (e.g., an inductively-coupled plasma source) and/or a metal ion source (e.g., a liquid-metal ion source). As with the electron beam column 107, the FIB column can include electromagnetic optics (e.g., electrostatic lenses, electromagnetic lenses, monochromators, etc.) and apertures configured to shape, focus, defocus, and direct the beam of ion such that the beam is focused onto the sample 130, in accordance with a set of operating parameters. The operating parameters can include a beam current, a beam energy (e.g., in volts, in electron volts, or the like), a magnification parameter, a scan pattern, a dwell time, and/or one or more pulse parameters. In this way, the example system 100 can function as a FIB to remove portions of the sample 130 and/or can be used for ion-beam assisted deposition of material onto the sample 130 (e.g., in coordination with the GIS 115). Analogous to the energies described in reference to the electron beam, above, the ion beam energy can be selected (e.g., by a user, by an algorithm initiated by a user, and/or automatically without user intervention) such that the beam delivers enough energy for beam-induced deposition to occur, but not such that the beam degrades the sample or degrades the precursor without forming deposited material layers on the sample 130. In some embodiments, additional and/or alternative precursor decomposition mechanisms (e.g., surface activation and/or secondary electron reemission) can be used as a mechanism for precursor decomposition, thereby allowing the ion beam energy to be determined based at least in part on a relationship between beam energy, sample material properties, and the energetic characteristics of the precursor deposition reaction mechanism. Advantageously, ion beam-induced deposition can elicit relatively high yields, in comparison to electron beam-induced deposition, based at least in part on the combined effect of multiple energy transfer pathways.

The GIS 115 includes constituent elements that together permit the GIS 115 to generate a gas stream including the precursor and to direct the gas stream into the vacuum chamber. The components of the GIS 115 can include a carrier gas inlet, a nozzle 119, and a conduit fluidically coupling the nozzle 119 and a precursor reservoir 117. The precursor reservoir 117 can include a substantially non-reactive container (e.g., a ceramic crucible, PTFE enclosure, a non-reactive metal or alloy, or the like) that is at least partially exposed to the conduit. In this way, vapor generated from a precursor disposed in the precursor reservoir 117 can be directed toward the nozzle and into the vacuum chamber (e.g., by pressure-driven flow induced by a pressure gradient relative to the vacuum of the vacuum chamber). In some embodiments, the GIS 115 includes a carrier gas inlet, fluidically coupled with the nozzle 119 via the conduit. In this way, the precursor can be entrained in a flow of carrier gas and directed toward the nozzle and into the vacuum chamber. Additionally and/or alternatively, the precursor can include a gas at standard conditions and can be introduced to the GIS 115 via a gas inlet provided as part of the GIS 115.

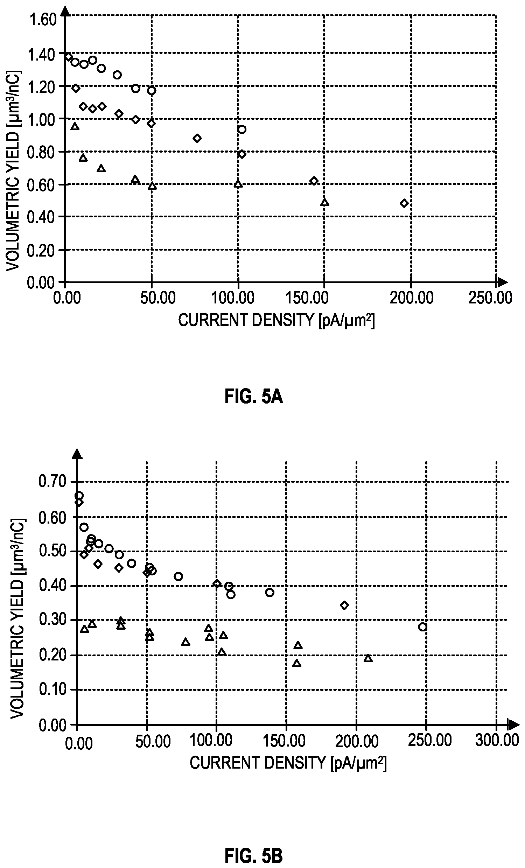

In an illustrative example, the precursor can be or include a material that is a solid at standard temperature and pressure and at least partially sublimates to form a vapor at reduced pressure and a temperature above about 273 K. To that end, the GIS 115 can include a heating circuit that is thermally coupled with the precursor reservoir and configured to heat the precursor to within a range of temperatures that elicits at least partial vaporization into the carrier gas flow. In some embodiments, the temperature can be from about 273 K to about 385 K, including sub-ranges, fractions, and interpolations thereof. The temperature can be selected based at least in part on a vapor pressure estimate for the precursor, as part of controlling the composition of the gas stream entering the vacuum chamber. Such estimates can be determined using empirically derived heuristics for a given charged particle beam system and/or can be derived using thermodynamic first principles. In some cases, the temperature and carrier gas flowrate can be selected based at least in part on an operational window determined from experimental calibration of a given charged particle beam system (e.g., for a given sample material and precursor material). Example data for such experiments are described in more detail in references to FIGs. 5A-6C.

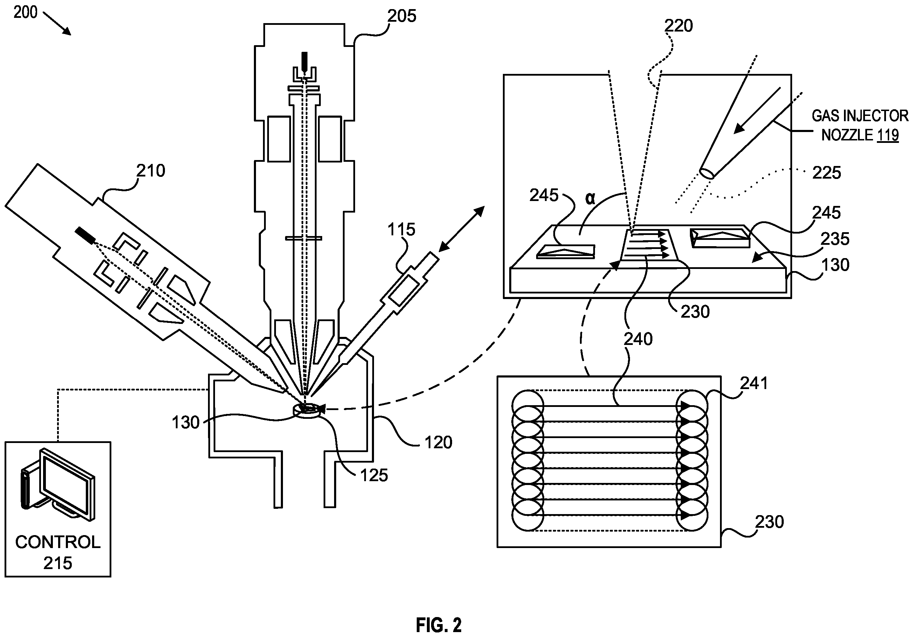

The operation of one or more components of the example system 100 can be coordinated by control circuitry (e.g., control system 215 of FIG. 2), in accordance with machine-executable instructions (e.g., software, firmware, etc.) that can be stored in machine-readable storage media and/or received from external systems via wired and/or wireless communication techniques (e.g., over a WiFi or Bluetooth link). To that end, components of the example system can be automated (e.g., operating without human intervention), pseudo-automated (e.g., operating with limited human intervention to initiate operations, analyze output and confirm, or the like), or manually operated (e.g., where individual operations of the example system 100 are performed by a human user). In an illustrative example, the sample stage 125 can be mechanically coupled with automated stage controls 127 that permit the sample 130 to be reversibly tilted relative to the beam axes A and B, such that the surface of the sample is substantially normal to a given beam axis during operation of the corresponding charged particle beam source. In this way, the operation of a given beam source can be coordinated with the operation of the stage controls 127. Similarly, the operation of the GIS 115 can be coordinated with the operation of the stage controls 127 and a given beam source (e.g., the electron beam source 105 and column 107), as described in more detail in reference to FIGs. 2-3.

Embodiments of the present disclosure omit one or more components of example system 100. For example, one or more of the sources 105 and 110 and/or columns 107 and 111 can be omitted. In an illustrative example, an SEM system can be configured to perform operations of the beam-induced deposition processes of the present disclosure. Similarly, a FIB system other than a dual-beam FIB-SEM (e.g., a FIB system for which two or more beam axes are not convergently trained on a given region of the sample 130) can include the GIS 115 oriented to be convergent with the second beam axis B.

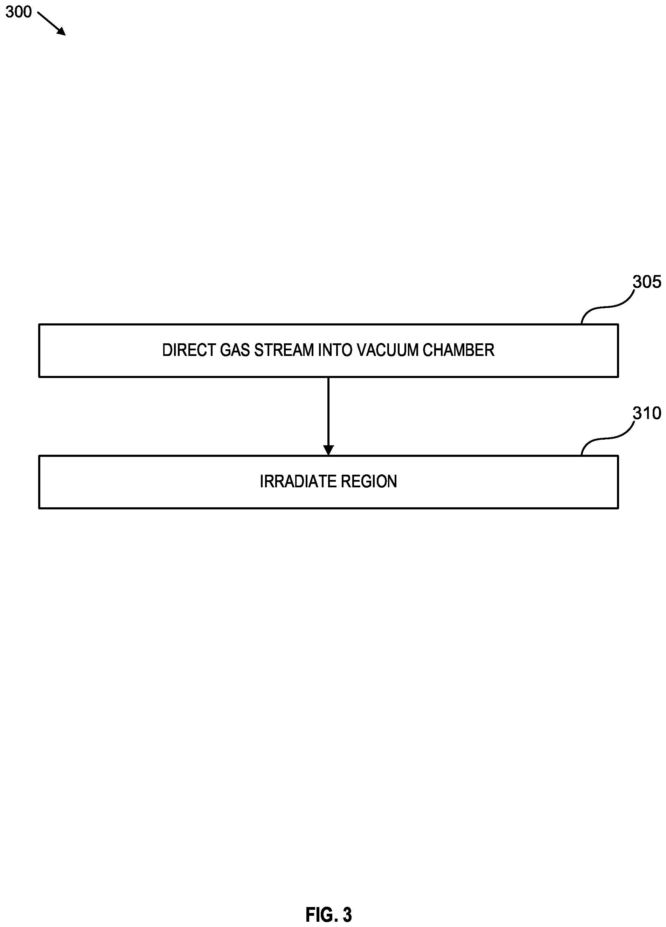

FIG. 2 is a schematic diagram illustrating an example charged particle beam system 200 performing operations of a process for beam-induced deposition, in accordance with some embodiments of the present disclosure. The example system 200 can include and/or omit some of the components of the example system 100 described in reference to FIG. 1. To that end, the example system 200 includes an SEM 205 (e.g., including electron source 105 and electron beam column 107), a FIB 210 (e.g., including ion source 110 and FIB column 111), a GIS 115, a vacuum chamber 120, and a sample stage 125 to which a sample 130 can be mechanically coupled. The example system 200 includes electronic control circuitry 215, by whose operation at least a portion of a beam-induced deposition process can be coordinated, as described in more detail in reference to FIG. 3.

The operations of the process for beam-induced deposition can include positioning the sample in the vacuum chamber such that the SEM 205, the FIB 210, and/or the GIS 115 are configured to direct a beam of charged particles 220 and/or a gas stream 225, respectively, toward a region of interest (ROI) 230 on the surface of the sample 235. In cases where the beam of charged particles 220 and the gas stream 225 are substantially convergent, the ROI 230 can include a locus in the vacuum chamber 120. In this context, the locus can be defined at least in part by an intersection of the beam axes A and B, the gas stream 225, and the position of the sample stage 125 in the vacuum chamber 120. In some embodiments, the GIS 115 can be repositioned relative to the locus such that GIS nozzle 119 can be moved relative to the sample 130, and the average concentration of precursor at the surface of the sample 235 can be controlled independently of the composition of the gas stream 225 itself (e.g., as determined by the operating parameters of the GIS 115).

An offset between the surface of the sample 235 and the sample stage can be estimated and/or measured using various techniques including focal-distance estimation in imaging mode using the SEM 205 and/or range-finding or profilometry techniques. The deposition process, therefore, can include positioning the sample stage 125 in the vacuum chamber 120 such that the surface of the sample 130 more generally, and the ROI 230 more specifically, coincides at least partially with the locus. Positioning the sample stage 125 can include tilting the sample stage 125, as described in more detail in reference to FIG. 1, such that the beam of charged particles 220 is oriented relative to the surface of the sample 235 at an angle, "α." The angle α can be from about 0 rad to about π rad, or about 0 deg to about 180 deg, where a value of about π/2 rad or 90 deg corresponds to substantially normal incidence of the beam of charged particles 220 with the surface of the sample 235. In some cases, the value of the angle α can be selected based at least in part on topography of the surface of the sample 235. For example, where the sample 130 includes surface features such as side-walls or other features oriented at a nonzero angle relative to the overall surface of the sample 235, the sample stage 125 can be oriented such that the angle α corresponds to substantially normal incidence of the beam of charged particles 220 and the local surface of the feature.

In some embodiments, the angle α can be dynamic during a deposition process. Advantageously, tilting the stage during a deposition process can be used to form substantially conformal coatings in an ROI 230 that includes topography that would otherwise produce shadows. In some embodiments, portions of the sample 130 can be used to generate secondary electrons, rather than directly irradiating the surface of the ROI 230. In this way, coating hidden surfaces (e.g., out of line of sight of the beam of charged particles 220) can be facilitated by directing the beam of charged particles 220 to positions around and/or within the ROI 230. To that end, for SEM 205 and/or FIB 210, the beam of charged particles 220 can be scanned across the surface of the sample 235, within and/or outside the ROI 230, in accordance with a scan pattern 240. The scan pattern 240 can include a linear translation across the surface of the sample 235, but can also include more complex patterns, such as raster patterns, geometric patterns, and discontinuous patterns.

The beam of charged particles 220 irradiates a portion of the surface of the sample 235 described by a spot size 241. To that end, the scan pattern 240 can be defined (e.g., as a time-dependent voltage signal or signals generated to control scan coils of the SEM 205) such that the beam spot overlaps at least partially as it rasters or otherwise transits across the surface of the sample 235. The average energy provided to the sample surface and localized secondary electron remission can be manipulated using an overlap percentage of the scan pattern 240 that can be determined based at least in part on geometric aspects of the spot size 241 and the scan pattern 240. Advantageously, this provides a variety of control parameters to improve the quality of deposited material layers 245.

As described in more detail in reference to the forthcoming figures, the dimensions, composition, spatial characteristics, surface properties, chemical properties, and physical properties of the deposited material layers 245 can be influenced by selecting a set of operating parameters for the example system 200. For example, the composition of the gas stream 225, the distance of the GIS nozzle 119 from the surface of the sample 235, and the volumetric flowrate of the gas stream 225 can independently affect the concentration of precursor near the surface of the sample 235 and/or the equilibrium surface coverage, θ, of precursor on the surface. As the equilibrium surface coverage θ also depends on environmental factors including the local temperature of the surface in the ROI 230, the pressure in the vacuum chamber 120, and the composition of the sample 130, beam-induced deposition can be modulated by multiple variables that do not involve SEM 205 or FIB 210 operating parameters. With respect to the SEM 205 and/or FIB 210 parameters, beam current, beam energy, spot size 241, dwell time, overlap percentage, and other aspects of the scan pattern 240 can be modulated to influence some or all of the same material properties of the layers 245.

FIG. 3 is a block flow diagram illustrating an example process 300 for beam-induced deposition, in accordance with some embodiments of the present disclosure. One or more operations of the example process 300 can be executed by a computer system in communication with additional systems including, but not limited to, characterization systems, network infrastructure, databases, and user interface devices. In some embodiments, at least a subset of the operations described in reference to FIG. 3 are performed automatically (e.g., without human involvement) or pseudo-automatically (e.g., with human initiation and/or limited human intervention). In an illustrative example, operations for generating a gas stream (e.g., gas stream 225 of FIG. 2), directing the gas stream toward a region of interest on a sample (e.g., ROI 230 of FIG. 2), and irradiating a region of the sample, using an analytical instrument system (e.g., example system 100 of FIG. 1).

At operation 305, example process 300 includes directing a gas stream into a vacuum chamber. As described in more detail in reference to FIGs. 1-2, the vacuum chamber can be a component of a charged particle beam system (e.g., a FIB, a SEM, an e-beam device, a dual-beam device, or the like). Operation 305 can include operations for flowing a carrier gas through a gas injection system (e.g., GIS 115 of FIG. 1) and for introducing a gaseous or vapor precursor into the carrier gas. The carrier gas can be an inert gas (e.g., a noble gas) or a reactive gas (e.g., a halogen-containing gas). For example, the carrier gas can include an inert component and a reactive component. The carrier gas can include a component that reacts with one or more fragments of a decomposed precursor and/or the precursor itself to form a material layer.

In some embodiments, the precursor includes a hydrocarbon having a vapor pressure greater than about 1.6×10⁻⁴ mbar at about 293 K and about 101.3 kPa. In some embodiments, the hydrocarbon includes one or more compounds excluding naphthalene. As naphthalene is included in a Substance Priority List compiled and publicly available in 2023 by the Agency for Toxic Substances and Disease Registry of the United States Centers for Disease Control, exclusion of naphthalene from the precursor reduces the environmental, health, and safety risks of example process 300. In some embodiments, the hydrocarbon includes a biphenyl. Biphenyl is not included in the same Substance Priority List, publicly available in 2023. The biphenyl can be at least partially substituted. The substituents can include one or more of methyl, ethyl, propyl, butyl, amine, amide, acetyl, carboxyl, phosphine, ketone, ether, among others. In some embodiments, the biphenyls exclude polychlorinated biphenyls. The hydrocarbon can include at least partially substituted naphthalene. Substituted naphthalene includes one or more substituents that are characterized by reduced hazard, with negligible or no reduction in performance as a deposition precursor. The hydrocarbon can include methane, ethylene, propane, styrene, camphor, menthol, benzoic acid, cyclohexane, cyclohexanone, cyanononane, acetone, methanol, nitromethane, acetonitrile, formic acid, acetic acid, propionic acid, acrylic acid, among others, each of which offer reduced hazard, relative to naphthalene in beam-induced deposition of carbon layers (e.g., material layers 245 of FIG. 2).

The analytical prediction of performance of a precursor in deposition using thermodynamic first principles can be complicated by unknown sample composition, local variation in surface conditions, challenges associated with precise measurement of gas stream composition, etc. As such, improved performance of a given precursor, relative to napthalene, can be estimated by comparing surface-precursor behavior in ideal systems. In this way, the range of chemicals that are available as carbon-deposition precursors can be understood to include those precursors that reach a substantially equal or greater equilibrium surface coverage, θ, relative to naphthalene at a given set of environmental conditions in the vacuum chamber and for a given sample, with θ being defined using a relevant adsorption isotherm model. Without being bound to a specific physical model or mechanism, it can be understood that a molecule with affinity for a given surface will perform well as a deposition precursor, where volatility of decomposition products and chemical reactivity with the substrate do not mitigate the effect. In a complementary approach, the precursor can characterized by a substantially equal or greater admolecule surface mobility, relative to naphthalene at a given set of environmental conditions in the vacuum chamber and for a given sample. The influence of surface mobility can be understood to improve flux of adsorbed species toward regions of low concentration, resulting for example from depletion of the precursor by beam-induced decomposition.

In some embodiments, operation 305 includes operations for generating a vapor of a solid or liquid precursor by sublimation and/or vaporization. In an illustrative example, biphenyl can be sublimated under vacuum at a temperature in a range from about 273 K to about 385 K, including sub-ranges, fractions, and interpolations thereof. To that end, operation 305 can include sub-operations by which the temperature of the precursor can be raised by a heating element in thermal contact with a reservoir of precursor (e.g., precursor reservoir 117 of FIG. 1) from ambient temperature by about 10 K, 20 K, 30 K, 40 K, 50 K, 60 K, 70 K, 80 K, 90 K, 100 K, 110 K, or more, including fractions and interpolations thereof. Heating the precursor can increase the pressure of precursor vapor in the GIS 115, such that the temperature of the precursor can be used to modulate the flow rate, precursor flux at the sample surface, and/or partial pressure of precursor gas stream and control for depletion of the precursor near the sample surface. To that end, heating below a temperature of about 273 K can result in depletion-limited deposition, while heating above about 385 K can introduce excess precursor into the chamber, risking contamination of the charged particle beam column(s) and/or the vacuum chamber components by deposition on chamber and column surfaces.

At operation 310, example process 300 includes irradiating a region of a sample surface. As described in more detail in reference to FIGs. 1-2, operation 310 can include radiation by beams of charged particles and/or photons. In some embodiments, operation 310 includes sub-operations for generating a beam of ions and directing the beam of ions toward a locus defined in a vacuum chamber of a charged particle beam system. As described in more detail in reference to FIG. 2, the locus can be defined by the intersection of beam axes in a dual-beam system (e.g., beam axes A and B of FIG. 1), but can also be defined by an intersection of a flow path of a GIS system and a beam axis for a charged particle source, at which a sample is positioned. Irradiating the region can include generating the beam of charged particles at a beam energy from about 1 keV to about 50 keV, including sub-ranges, fractions, and interpolations thereof. Irradiating the region can include directing a current density from about 0.1 pA/µm² to about 300 pA/µm² onto a surface positioned substantially at the locus, including sub-ranges, interpolations, and fractions thereof. As described in more detail in reference to FIGs. 5A-6C, the volumetric yield of deposited material can be effectively controlled by modulating the current density. Current density, in turn, can be modulated using beam parameters including beam current, size of the scan pattern, and spot size.

The operations of example process 300 are presented in an exemplary sequence, but one or more operations can be reordered, repeated, omitted, and/or parallelized. Further, additional and/or alternative operations can be included as part of example process 300, and some operations preceding and/or following those described in reference to FIG. 3 could form a part of a processing workflow. For example, the operations of example process 300 could follow one or more operations for removing at least a portion of a sample, using a FIB (e.g., FIB 210 of FIG. 2) and could precede one or more operations for extracting a portion of the sample for further microanalysis, for example, using a TEM. In another example, SEM imaging operations can be implemented during the execution of the operations of example process 300. To that end, the example process 300 includes operations directed at beam-induced deposition that can form a part of a larger sample preparation procedure, in some embodiments.

### EXAMPLE 1 - ION BEAM INDUCED DEPOSITION

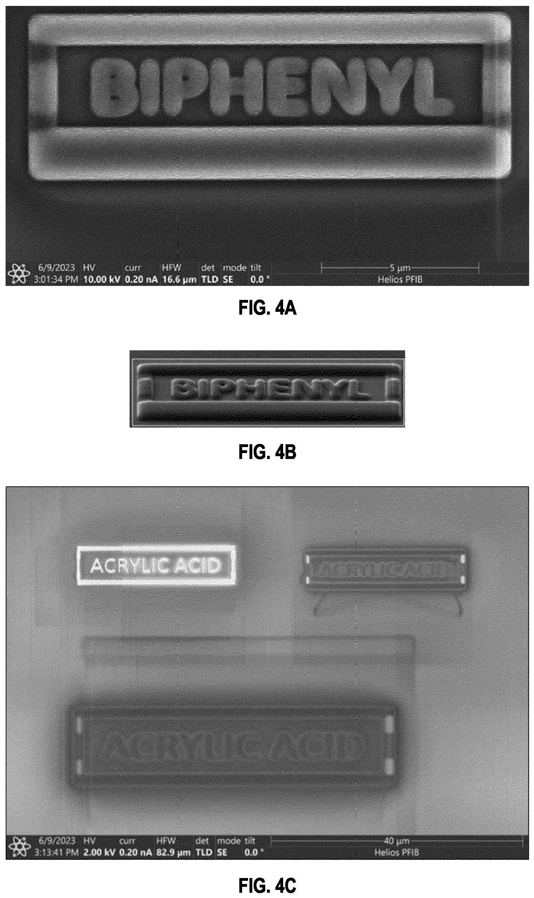

FIG. 4A is an electron micrograph of an example sample surface on which a carbonaceous material has been disposed using a biphenyl precursor, prepared in accordance with some embodiments of the present disclosure. The micrograph demonstrates that a biphenyl precursor can be used to deposit a substantially conformal coating on a surface that is localized to a region of the surface that has been irradiated using an ion beam. In the case of FIG. 4A, the surface was irradiated using a scan pattern that reproduced the word "biphenyl" in a rectangular cartouche. The volumetric nature of the deposition is illustrated in FIG. 4B.

FIG. 4B is an electron micrograph of the example carbonaceous material of FIG. 4A, in partial elevation, prepared in accordance with some embodiments of the present disclosure. As shown, the localization of deposition is preserved in the regions irradiated while also producing a substantially uniform deposition height. The deposition height, in turn, can be controlled using beam and/or gas flow parameters, as demonstrated by the raised regions and the recessed regions of the cartouche. While the lettering presents a substantially uniform height, four regions of the cartouche are recessed relative to the lettering.

FIG. 4C is an electron micrograph of an example sample surface on which a carbonaceous material has been disposed using an acrylic acid precursor, prepared in accordance with some embodiments of the present disclosure. Similar to the images in FIG. 4A and FIG. 4B, an acrylic acid precursor was shown to form a localized deposition corresponding to irradiation with an ion beam.

FIGs. 5A-5B are data plots illustrating the influence of operating parameters of an example charged particle beam system on performance in beam-induced deposition using biphenyl precursor, in accordance with embodiments of the present disclosure. In each graph, the horizontal, x-axis, describes current density as an independent variable, while the vertical, y-axis, describes volumetric yield as a dependent variable. Volumetric yield describes a volume of deposited material per unit of charge and is a useful metric by which to gauge the effectiveness of a precursor to deposit material. Advantageously, the biphenyl precursor used in these trials does not exhibit the same environmental, health, or safety risks presented by the continued use of naphthalene, while still performing well as a deposition precursor in both liquid-metal and gas ion sources. As described in more detail in reference to Example 2, below.

In FIG. 5A, data are presented for three operating conditions. The first set of data, using circle "o" markers, corresponds to deposition using a beam of Xe⁺ ions at 5 keV and 1 nA. The second set of data, using diamond "0" markers, corresponds to deposition using a beam of Xe⁺ ions at 12 keV and 1 nA. The third set of data, using triangle "Δ" markers, corresponds to deposition using a beam of Xe⁺ ions at 12 keV and 70 nA. FIG. 5A reveals that each operating condition produced a measurable volumetric yield of deposited carbonaceous layer. Volumetric yield improved at the lower beam energy value of 5 keV and tended to decrease at higher current densities for all values of beam energy and beam current.

In FIG. 5B, the relative influence of beam current is illustrated in a set of data generated using three different values of beam current, 77 pA ("o"), 0.77 nA ("0"), and 8.9 nA ("Δ ") for a single beam energy of 30 keV using Ga⁺ ions. Increasing current beyond about 1 nA appeared to have a detrimental influence on volumetric yield. Like the trend observed in FIG. 5A, current density and volumetric yield appeared to be inversely correlated.

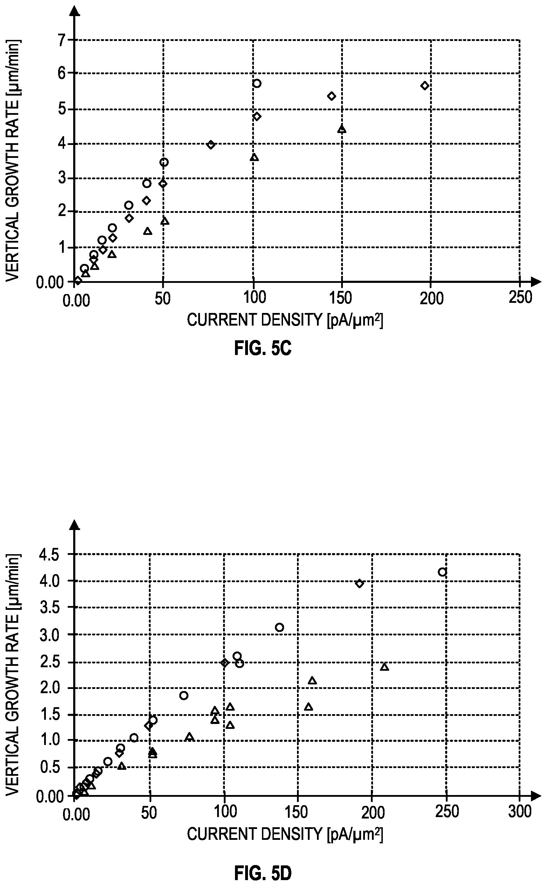

In FIG. 5C, the influence of current density on vertical growth rate is illustrated in a set of data generated using two different values of beam energy, 5 keV ("o") and 12 keV for two different currents of 1 nA ("◊") and 70 nA ("Δ") using Xe⁺ ions. Increasing current density beyond about 100 pA/µm² appeared to have a detrimental influence on rate. Unlike the prior data, the data of FIG. 5C reveal a direct correlation between growth rate and current density that exhibits diminishing growth with increasing current density. The growth rate appears to be consistent for different values of beam energy and relatively insensitive to beam current, with a reduction in growth rate of about 20% being observed between a current of 1 nA and a current of 70 nA. Advantageously, the current behavior reveals that biphenyl is a suitable precursor for carbon deposition over a wide range of operating conditions, including plasma-FIB gas ion sources.

In FIG. 5D, the influence of current density on vertical growth rate is illustrated in a set of data generated using a beam energy of 30 keV and three different beam currents of 77 pA nA ("o"), 0.77 nA("◊"), and 8.9 nA ("Δ") using Ga⁺ ions. Like the data of FIG. 5C, the data of FIG. 5D reveal a direct correlation between growth rate and current density that exhibits diminishing growth with increasing current density. The growth rate appears to be relatively insensitive to beam current, with a reduction in growth rate of about 40% being observed over a range greater than 100x the lower bound of 0.077 nA to 8.9 nA. Advantageously, the current behavior reveals that biphenyl is a suitable precursor for carbon deposition over a wide range of operating conditions, including in liquid metal ion sources.

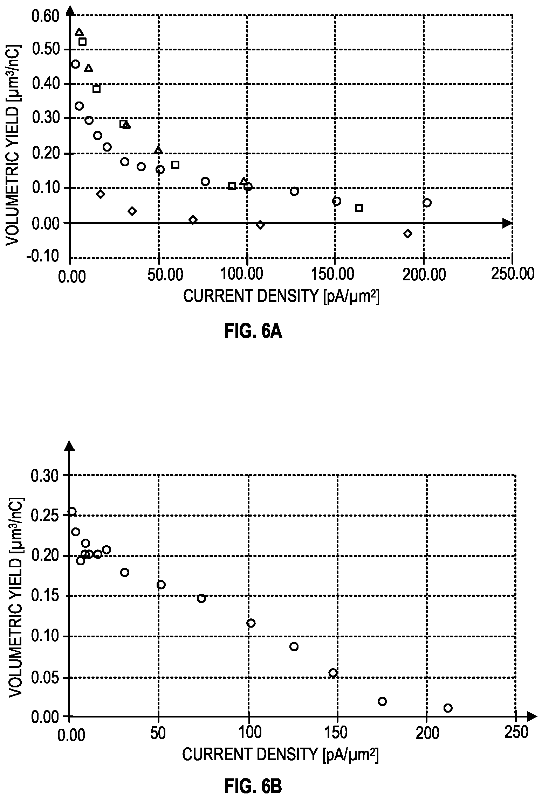

FIGs. 6A-6B are data plots illustrating the influence of operating parameters of an example charged particle beam system on performance in beam-induced deposition using an acrylic acid precursor, in accordance with embodiments of the present disclosure. In each graph, the horizontal, x-axis, describes current density as an independent variable, while the vertical, y-axis, describes volumetric yield as a dependent variable. Volumetric yield describes a volume of deposited material per unit of charge and is a useful metric by which to gauge the effectiveness of a precursor to deposit material. Advantageously, the acrylic acid precursor used in these trials does not exhibit the same environmental, health, or safety risks presented by the continued use of naphthalene, while still performing well as a deposition precursor.

In FIG. 6A, the relative influence of beam energy is illustrated in a set of data generated using three different values of beam energy, 5 keV ("o"), 12 keV ("□" and "Δ"), and 30 keV ("◊") for a current of 1 nA using Xe⁺ ions. Increasing current density beyond about 10 pA/µm² appeared to have a detrimental influence on volumetric yield. Like the trend observed in FIGs. 5A-5B, current density and volumetric yield appeared to be inversely correlated. Advantageously, the data of FIG. 6A show that acrylic acid is a suitable carbon deposition precursor at relatively low current densities (e.g., below about 10 pA/µm²), allowing deposition to proceed with relatively little risk of damage to the sample caused by the beam of charged particles.

In FIG. 6B, the relative influence of beam energy is illustrated in a set of data generated using a beam energy of 30 keV ("o") and a current of 0.8 nA of Ga⁺ ions. Similar to the trend observed in FIGs. 5A-5B and FIG. 6A, current density and volumetric yield appeared to be inversely correlated. Advantageously, the data of FIG. 6B show that acrylic acid is a suitable carbon deposition precursor for a liquid-metal ion source at relatively low current densities (e.g., below about 10 pA/µm²), allowing deposition to proceed with relatively little risk of damage to the sample caused by the beam of charged particles.

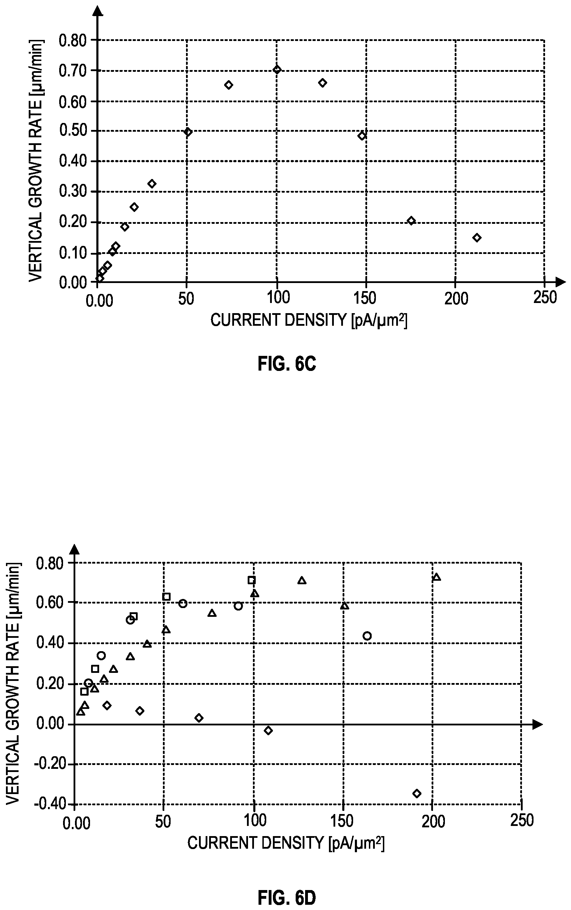

In FIG. 6C, the influence of current density on vertical growth rate is illustrated in a set of data generated using a beam energy of 30 keV ("◊") and a current of 0.8 nA using Ga⁺ ions. Increasing current density beyond about 100 pA/µm² appeared to have a detrimental influence on vertical growth rate. Unlike the prior data, the data of FIG. 6C reveal a non-linear relationship between growth rate and current density that correlates to a threshold density beyond which material deposition can be degraded by excess ion flux. When seen in the context of the data of FIG. 6B, these data support the results of volumetric yield in FIG. 6B and the use of acrylic acid as a carbon deposition precursor.

In FIG. 6D, the influence of current density on vertical growth rate is illustrated in a set of data generated using three different values of beam energy, 5 keV ("Δ"), 12 keV ("∘" and "□"), and 30 keV ("◊") for a beam current of 1 nA Xe⁺ ions. Similar to the trend observed in FIGs. 5C-5D, the data of FIG. 6D reveal a direct correlation between growth rate and current density for values of beam energy below about 15 keV that exhibits diminishing growth with increasing current density. For the data collected at 30 keV, however, an inverse correlation is observed. The growth rate appears to be consistent for different values of beam energy, except for the data at 30 keV. These data support the results of volumetric yield of FIG. 6A and the use of acrylic acid as a carbon deposition precursor at beam energies below about 30 keV.

### EXAMPLE 2 - IMPROVED DEPOSITION RELATIVE TO NAPHTHALENE

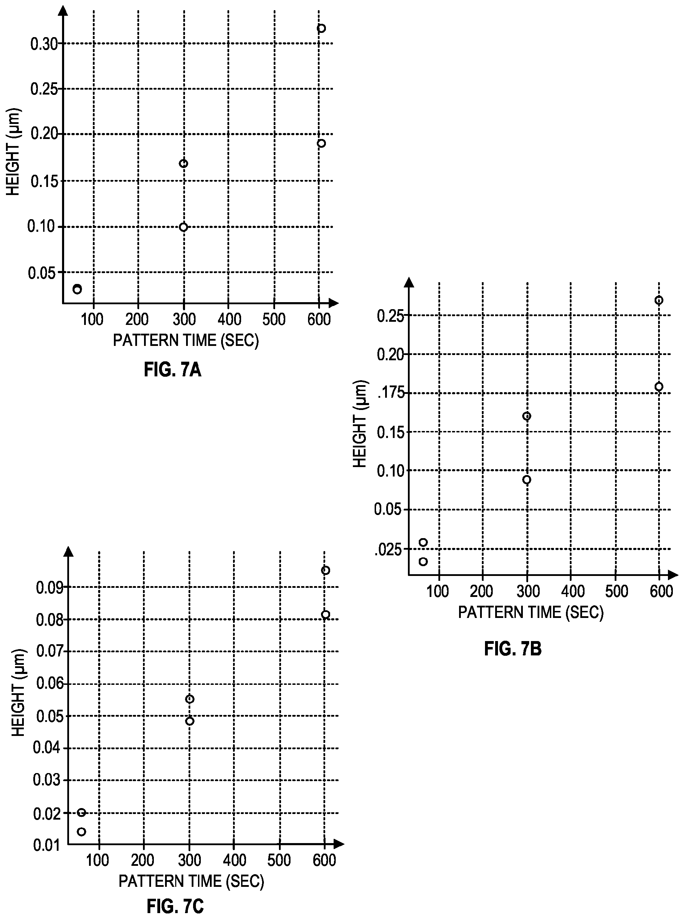

FIGs. 7A-7C are data plots illustrating comparative data generated using an example charged particle beam system in electron beam-induced deposition using biphenyl precursor and naphthalene precursor, in accordance with embodiments of the present disclosure. In each graph, the horizontal, x-axis, describes pattern time as an independent variable, in seconds, while the vertical, y-axis, describes vertical height, in micrometers (µm) as a dependent variable. Pattern time describes a duration of time over which a sample is irradiated by a beam of charged particles in the presence of a precursor and can be used as an input parameter to modulate charged particle dose.

FIG. 7A illustrates comparative data for electron beam-induced deposition of carbonaceous material from biphenyl precursor in filled circles ("●") and naphthalene precursor in hollow circles ("o"). In the trials from which the data were generated, the primary electron beam had an energy of about 1 kiloelectronvolts (keV) and a beam current of about 2000 picoamperes. Biphenyl outperformed naphthalene as a precursor, in terms of height as a function of pattern time. Advantageously, the relatively faster deposition of material from the biphenyl precursor, as a function of pattern time, permits material of comparable thickness to be formed in a relatively shorter time, allowing reduced electron dose at the sample and reduced preparation time, each representing improvements to the performance of an overall sample preparation procedure.

FIG. 7B-7C illustrate comparative data for electron beam-induced deposition of carbonaceous material from biphenyl precursor in filled circles ("●") and naphthalene precursor in hollow circles ("o"). In the trials from which the data were generated, the primary electron beam in FIG. 7B had an energy of about 2 keV and a beam current of about 2000 picoamperes. The primary electron beam in FIG. 7C had an energy of about 5 keV and a beam current of about 2000 picoamperes.

As in the data from FIG. 7A, trials at relatively higher beam energy indicate that Biphenyl outperformed naphthalene as a precursor, in terms of height as a function of pattern time. Advantageously, the relatively faster deposition of material from the biphenyl precursor, as a function of pattern time, permits material of comparable thickness to be formed in a relatively shorter time, allowing reduced electron dose at the sample and reduced preparation time, each representing improvements to the performance of an overall sample preparation procedure.

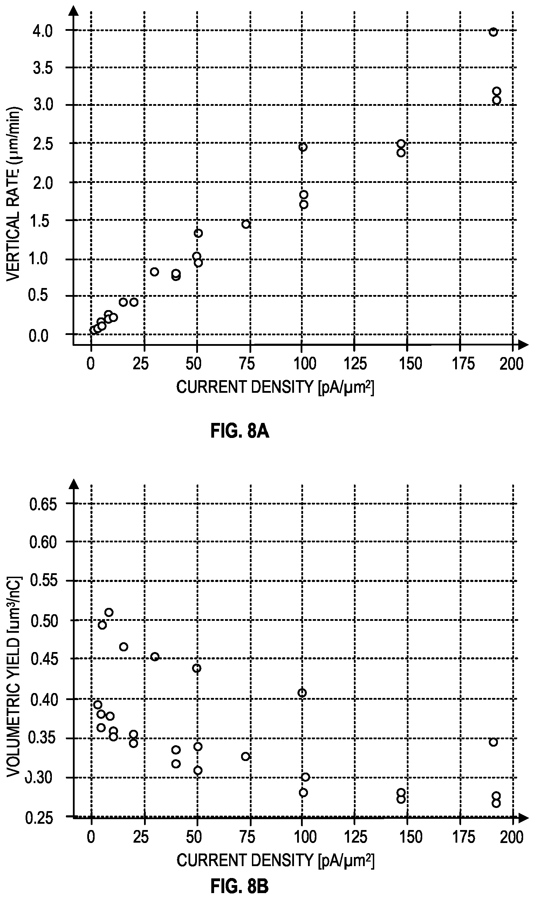

FIGs. 8A-8B are data plots illustrating comparative data generated using an example charged particle beam system in gallium ion beam-induced deposition using biphenyl precursor and naphthalene precursor, in accordance with embodiments of the present disclosure. In each graph, the horizontal, x-axis, describes current density as an independent variable. In FIG. 8A, the vertical, y-axis, describes vertical rate, in micrometers per minute (µm/min) as a dependent variable. In FIG. 8B, the vertical axis describes volumetric yield, which is a measure of a volume of deposited material per unit of charge and is a useful metric by which to gauge the effectiveness of a precursor to deposit material.

FIG. 8A illustrates comparative data for ion beam-induced deposition of carbonaceous material from biphenyl precursor in filled circles ("●") and naphthalene precursor in hollow circles ("o"). In the trials from which the data were generated, the primary ion beam had an energy of about 30 kiloelectronvolts (keV) and a beam current of about 770 picoamperes. Biphenyl outperformed naphthalene as a precursor, in terms of deposition rate as a function of current density. Advantageously, the relatively faster deposition of material from the biphenyl precursor, as a function of dose per unit surface area, permits material of comparable thickness to be formed in a relatively shorter time, allowing reduced ion dose at the sample and reduced preparation time, each representing improvements to the performance of an overall sample preparation procedure.

FIG. 8B illustrates comparative data for ion beam-induced deposition of carbonaceous material from biphenyl precursor in filled circles ("●") and naphthalene precursor in hollow circles ("o"). In the trials from which the data were generated, the primary ion beam in FIG. 8B had an energy of about 30 keV and a beam current of about 770 picoamperes. As in the data from FIG. 8A, data in FIG. 8B indicate that Biphenyl outperformed naphthalene as a precursor with a relatively higher volumetric yield at each value of current density. Advantageously, the relatively higher yield of material from the biphenyl precursor, for a given current density, permits material of comparable volume to be formed in a relatively shorter time, allowing reduced electron dose at the sample and reduced preparation time, each representing improvements to the performance of an overall sample preparation procedure.

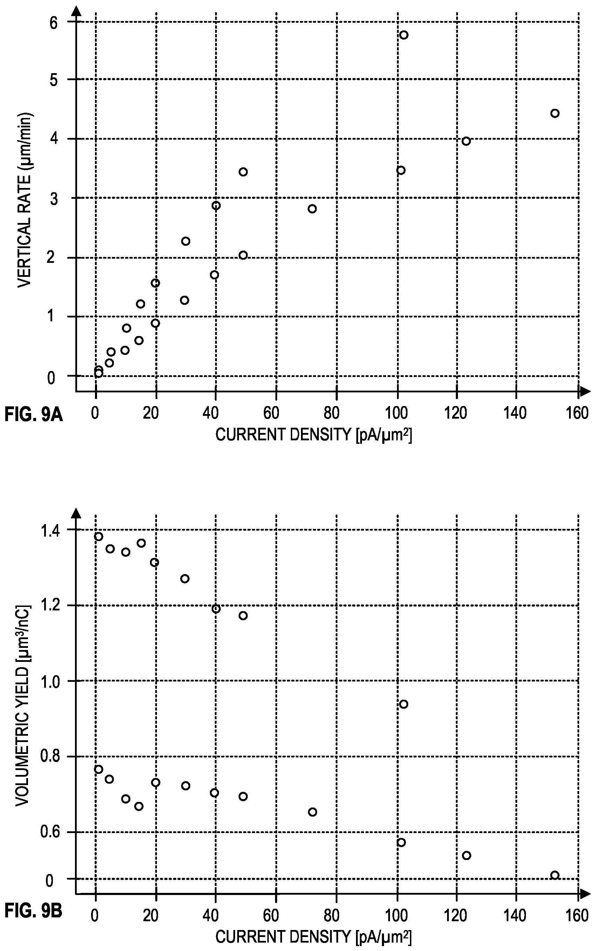

FIGs. 9A-9B are data plots illustrating comparative data generated using an example charged particle beam system in xenon ion beam-induced deposition using biphenyl precursor and naphthalene precursor for various operating conditions, in accordance with embodiments of the present disclosure. In each graph, the horizontal, x-axis, describes current density as an independent variable, in seconds. In FIG. 9A, the vertical, y-axis, describes vertical rate, in micrometers per minute (µm/min) as a dependent variable. In FIG. 9B, the vertical axis describes volumetric yield. In the trials from which the data were generated, the primary ion beam had an energy of about 12 keV and a beam current of about 1000 picoamperes.

FIG. 9A illustrates comparative data for xenon ion beam-induced deposition of carbonaceous material from biphenyl precursor in filled circles ("●") and naphthalene precursor in hollow circles ("o"). Biphenyl outperformed naphthalene as a precursor, in terms of deposition rate as a function of current density. Similarly FIG. 9B illustrates comparative data for xenon ion beam-induced deposition of carbonaceous material from biphenyl precursor in filled circles ("●") and naphthalene precursor in hollow circles ("o"). As in the data from FIG. 9A, data in FIG. 9B indicate that Biphenyl outperformed naphthalene as a precursor with a relatively higher volumetric yield at each value of current density. Advantageously, the relatively higher yield of material from the biphenyl precursor, for a given current density, permits material of comparable volume to be formed in a relatively shorter time, allowing reduced ion dose at the sample and reduced preparation time, each representing improvements to the performance of an overall sample preparation procedure.

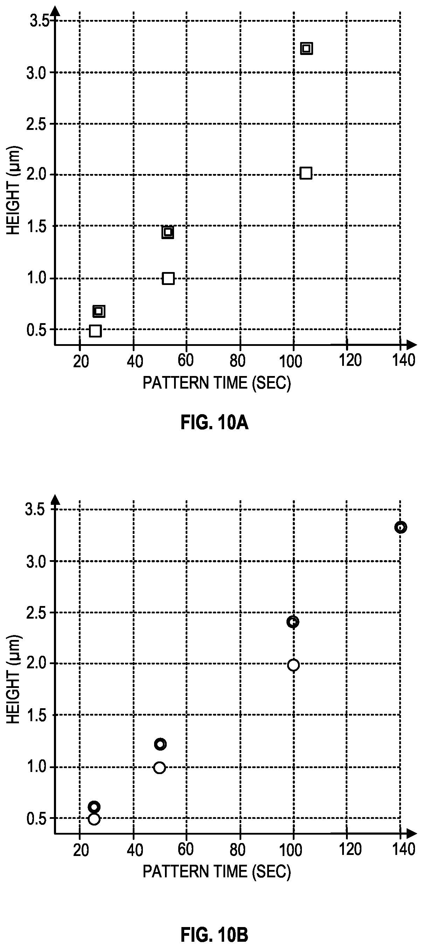

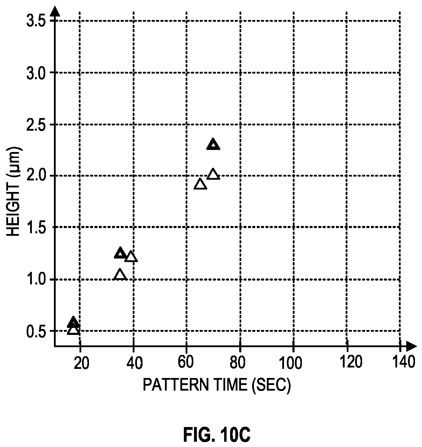

FIGs. 10A-10C are data plots illustrating comparative data generated using an example charged particle beam system in gallium ion beam-induced deposition using biphenyl precursor and naphthalene precursor, in accordance with embodiments of the present disclosure. FIGs. 10A-10C reproduce the findings of FIGs. 8A-8B, for a gallium ion beam having an energy of about 2 keV, 5 keV, 30 keV, respectively and a beam current of about 340 picoamperes, 690 picoamperes, and 770 picoamperes, respectively. As in preceding graphs, data for biphenyl precursor is shown in filled circles ("●") and naphthalene precursor in hollow circles ("o"). Advantageously, the data from FIGs. 10A-10C demonstrate that biphenyl outperforms naphthalene as a deposition precursor for ion beam induced deposition, as well as, electron beam induced deposition, across relatively wide operational windows.

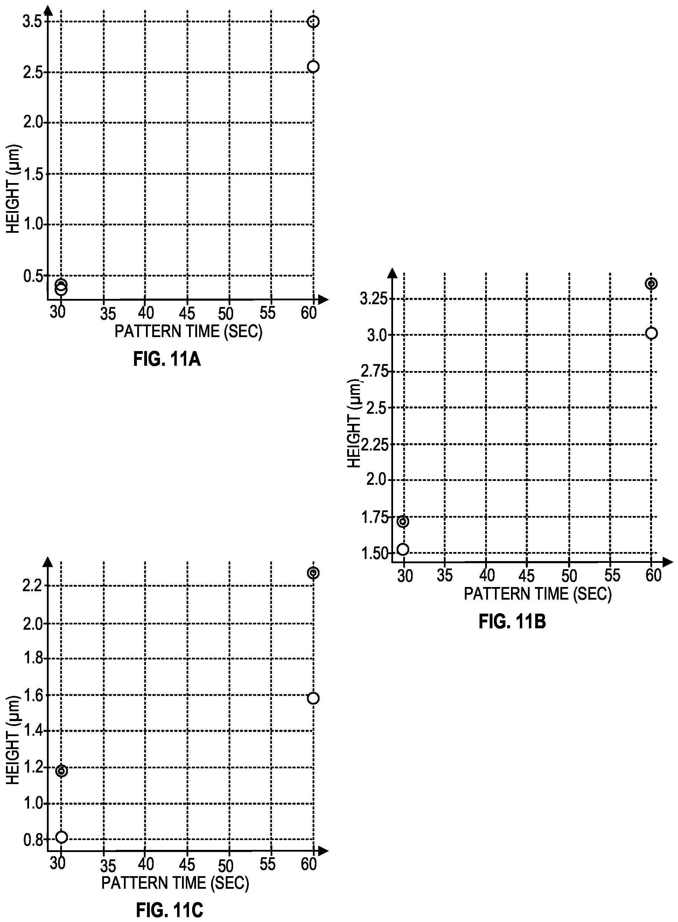

FIGs. 11A-11C are data plots illustrating comparative data generated using an example charged particle beam system in argon ion beam-induced deposition using biphenyl precursor and naphthalene precursor, in accordance with embodiments of the present disclosure. In each graph, the horizontal, x-axis, describes pattern time as an independent variable, in seconds, while the vertical, y-axis, describes vertical height, in micrometers (µm) as a dependent variable.

FIGs. 11A-11C reproduce the findings of FIGs. 7A-7C and FIGs. 10A-10C, for an argon ion beam having an energy of about 30 keV, about 12 keV, and about 5 keV, respectively and a beam current of about 740 picoamperes, about 1200 picoamperes, and about 580 picoamperes, respectively. As in preceding graphs, data for biphenyl precursor is shown in filled circles ("●") and naphthalene precursor in hollow circles ("o"). Advantageously, the data from FIGs. 11A-11C demonstrate that biphenyl outperforms naphthalene as a deposition precursor for ion beam induced deposition, as well as, electron beam induced deposition, across relatively wide operational windows. Further, FIGs. 11A-11C demonstrate that biphenyl performs well as a deposition precursor for multiple noble gas ion sources, as well as for metal ion sources.

In the preceding description, various embodiments have been described. For purposes of explanation, specific configurations and details have been set forth in order to provide a thorough understanding of the embodiments. However, it will also be apparent to one skilled in the art that the embodiments may be practiced without the specific details. Furthermore, well-known features may have been omitted or simplified in order not to obscure the embodiment being described. While example embodiments described herein center on charged particle beam systems, and focused ion beam systems in particular, these are meant as non-limiting, illustrative embodiments. Embodiments of the present disclosure are not limited to such embodiments, but rather are intended to address analytical instruments systems for which a wide array of material samples can be processed to prepare samples for further microanalysis of chemical, biological, physical, structural, or other properties, among other aspects, including but not limited to phase structure, trace element composition, or the like.

Some embodiments of the present disclosure include a system including one or more data processors and/or logic circuits. In some embodiments, the system includes a non-transitory computer readable storage medium containing instructions which, when executed on the one or more data processors and/or logic circuits, cause the one or more data processors and/or logic circuits to perform part or all of one or more methods and/or part or all of one or more processes and workflows disclosed herein. Some embodiments of the present disclosure include a computer-program product tangibly embodied in non-transitory machine-readable storage media, including instructions configured to cause one or more data processors and/or logic circuits to perform part or all of one or more methods and/or part or all of one or more processes disclosed herein.

The terms and expressions which have been employed are used as terms of description and not of limitation, and there is no intention in the use of such terms and expressions of excluding any equivalents of the features shown and described or portions thereof, but it is recognized that various modifications are possible within the scope of the claims. Thus, it should be understood that although the present disclosure includes specific embodiments and optional features, modification and variation of the concepts herein disclosed may be resorted to by those skilled in the art, and that such modifications and variations are considered to be within the scope of the appended claims.

Where terms are used without explicit definition, it is understood that the ordinary meaning of the word is intended, unless a term carries a special and/or specific meaning in the field of charged particle microscopy systems or other relevant fields. The terms "about" or "substantially" are used to indicate a deviation from the stated property within which the deviation has little to no influence of the corresponding function, property, or attribute of the structure being described. In an illustrated example, where a dimensional parameter is described as "substantially equal" to another dimensional parameter, the term "substantially" is intended to reflect that the two parameters being compared can be unequal within a tolerable limit, such as a fabrication tolerance or a confidence interval inherent to the operation of the system. Similarly, where a geometric parameter, such as an alignment or angular orientation, is described as "about" normal, "substantially" normal, or "substantially" parallel, the terms "about" or "substantially" are intended to reflect that the alignment or angular orientation can be different from the exact stated condition (e.g., not exactly normal) within a tolerable limit. For dimensional values, such as diameters, lengths, widths, or the like, the term "about" can be understood to describe a deviation from the stated value of up to ±10%. For example, a dimension of "about 10 mm" can describe a dimension from 9 mm to 11 mm.

The description provides exemplary embodiments, and is not intended to limit the scope, applicability, or configuration of the disclosure. Rather, the ensuing description of the exemplary embodiments will provide those skilled in the art with an enabling description for implementing various embodiments. It is understood that various changes may be made in the function and arrangement of elements without departing from the spirit and scope as set forth in the appended claims. Specific details are given in the description to provide a thorough understanding of the embodiments. However, it will be understood that the embodiments may be practiced without these specific details. For example, specific system components, systems, processes, and other elements of the present disclosure may be shown in schematic diagram form or omitted from illustrations in order not to obscure the embodiments in unnecessary detail. In other instances, well-known circuits, processes, components, structures, and/or techniques may be shown without unnecessary detail.

## Claims

1. A charged particle beam system, comprising:
a vacuum chamber;
a charged particle beam source, operably coupled with the vacuum chamber and including an emitter section and a column section, the charged particle beam source being configured to generate a beam of charged particles and to direct the beam of charged particles into the vacuum chamber; and
a precursor source, operably coupled with the vacuum chamber and configured to direct a gas stream comprising a precursor into the vacuum chamber,
wherein the precursor comprises a hydrocarbon having a vapor pressure greater than about 1.6×10⁻⁴ mbar at about 293 K and about 101.3 kPa, and wherein the hydrocarbon is not naphthalene.

2. The system of claim 1, wherein the hydrocarbon is not included in the Substance Priority List compiled by the Agency for Toxic Substances and Disease Registry of the United States Centers for Disease Control as of 2023.

3. The system of claim 1 or claim 2, wherein the hydrocarbon comprises a biphenyl or a substituted-naphthalene, preferably wherein the biphenyl includes one or more substituents, selected from a group consisting of: methyl, ethyl, propyl, butyl, amine, amide, acetyl, carboxyl, phosphine, ketone, and ether.

4. The system of claim 1 or claim 2, wherein the hydrocarbon is selected from a group consisting of: methane, ethylene, propane, styrene, camphor, menthol, benzoic acid, cyclohexane, cyclohexanone, cyanononane, acetone, methanol, nitromethane, acetonitrile, formic acid, acetic acid, propionic acid, and acrylic acid.

5. The system of any preceding claim, wherein the precursor reaches a substantially equal or greater equilibrium surface coverage, θ, relative to that of naphthalene at a given set of environmental conditions in the vacuum chamber and for a given sample, with θ being defined using a relevant adsorption isotherm model, and/or wherein the precursor is **characterized by** a substantially equal or greater admolecule surface mobility, relative to that of naphthalene at a given set of environmental conditions in the vacuum chamber and for a given sample.

6. The system of any preceding claim, further comprising a sample stage, disposed in the vacuum chamber and defining a locus in the vacuum chamber such that the charged particle beam source and the precursor source are configured to direct the beam of charged particles and the gas stream, respectively, toward the locus.

7. The system of any preceding claim, further comprising:
control circuitry, operably coupled with the charged particle beam source and the precursor source; and
one or more non-transitory machine-readable storage media, operably coupled with the control circuitry and storing instructions that, when executed by the system, cause the system to perform operations comprising:
directing the gas stream into the vacuum chamber toward a locus defined in the vacuum chamber; and
irradiating a region including the locus using the beam of charged particles.

8. The system of claim 7, wherein irradiating the region comprises directing a current density from about 0.1 pA/µm² to about 300 pA/µm² onto a surface positioned substantially at the locus.

9. The system of claim 7 or claim 8, wherein the operations further comprise heating the precursor at a temperature from about 273 K to about 385 K.

10. A method of generating a carbonaceous material in a charged particle beam system, the method comprising:
directing a gas stream into a vacuum chamber of the charged particle beam system, the gas stream comprising a precursor, wherein the precursor comprises a hydrocarbon having a vapor pressure greater than about 1.6×10⁻⁴ mbar at about 293 K and about 101.3 kPa, and wherein the hydrocarbon is not naphthalene; and
irradiating a region of a sample using a beam of charged particles.

11. The method of claim 10, wherein the hydrocarbon is a biphenyl, preferably wherein the biphenyl includes one or more substituents, selected from a group consisting of: methyl, ethyl, propyl, butyl, amine, amide, acetyl, carboxyl, phosphine, ketone, and ether.

12. The method of claim 10 or claim 11, wherein the beam of charged particles comprises argon ions, xenon ions or gallium ions, and/or wherein the beam of charged particles comprises electrons.

13. The method of any one of claims 10 to 12, wherein the beam of charged particles has a current density from about 0.1 pA/µm² to about 300 pA/µm².

14. The method of any one of claims 10 to 13, wherein the beam of charged particles has a beam energy from about 1 keV to about 50 keV.

15. The method of any one of claims 10 to 14, further comprising heating the precursor to a temperature from about 273 K to about 385 K.
